# EUROPEAN PATENT SPECIFICATION

(11) **EP 3 127 647 B1**
(45) Date of publication and mention of the grant of the patent: **12.08.2020**
(21) Application number: 15772918.7
(22) Date of filing: 27.03.2015
(51) Int. Cl.: B23K 20/00, B32B 15/01, B23K 35/02, B23K 20/04, B23K 20/227, H01J 37/34, B23K 20/16, B23K 20/24, B23K 20/02, B23K 103/02, B23K 103/04, B23K 103/08, B23K 103/10, B23K 103/14, B23K 103/16, B23K 103/18, B23K 103/20

(54) **METHOD FOR PRODUCING METAL LAMINATE MATERIAL**
VERFAHREN ZUR HERSTELLUNG VON METALLLAMINATMATERIAL
PROCÉDÉ POUR PRODUIRE UN MATÉRIAU STRATIFIÉ MÉTALLIQUE

(30) Priority: 01.04.2014 JP 2014075586
(43) Date of publication of application: 08.02.2017
(73) Proprietor: Toyo Kohan Co., Ltd., Tokyo 102-8447 (JP)
(72) Inventor: NANBU Kouji, Kudamatsu-shi Yamaguchi 744-8611 (JP); KUROKAWA Teppei, Kudamatsu-shi Yamaguchi 744-8611 (JP); KOSHIRO Takashi, Kudamatsu-shi Yamaguchi 744-8611 (JP); OKAYAMA Hironao, Kudamatsu-shi Yamaguchi 744-8611 (JP)
(74) Representative: Kordel, Mattias
(86) International application number: PCT/JP2015/059593
(87) International publication number: WO 2015/152040

(56) References cited:
- EP-A1- 0 091 371
- JP-A- H0 970 918
- JP-A- H02 133 563
- JP-A- S61 286 078
- JP-A- S63 137 591
- JP-A- 2002 206 128
- JP-A- 2004 306 458
- JP-A- 2005 074 913
- JP-A- 2005 074 913
- JP-A- 2006 159 797
- US-A- 4 245 768
- US-A- 4 483 478
- US-A- 4 815 652
- US-A- 4 896 813
- US-A1- 2013 040 821
- Peter S Doidge: "Determination of Trace Impurities in High-Purity Copper by Sequential ICP-OES with Axial Viewing Author", , 1 November 2010 (2010-11-01), XP055400853, Retrieved from the Internet: URL:http://www.agilent.com/cs/library/appl ications/ICPES-25.pdf [retrieved on 2017-08-24]

## Description

### Technical Field

The present invention relates to a method for producing a metal laminate material.

### Background Art

Metal laminate materials (clad materials), which are materials prepared by bonding two or more different metals to one another, are high-functional metal materials having composite properties not achievable with a single material. Such metal laminate materials have been conventionally produced by undergoing steps such as cleaning faces to be bonded and rolling bonding. For example, (Patent Literature 1; US 2013/040821 A1, JP S63 137591 A, JP 2005 074913 A) discloses a method for producing a clad metal plate, wherein, after the faces to be bonded of dissimilar metal sheets are activated in advance by sputter etching treatment in an extremely low pressure inert gas atmosphere in a vacuum vessel, the dissimilar metal sheets are polymerized to thereby be subjected to cold rolling bonding. This method enables a thin clad metal to be obtained which forms no alloy layer on the bonding interface and has high bonding strength and excellent processability.

Unfortunately, the production method of the aforementioned (Patent Literature 1) requires complete removal of oxide layers on the surface layer of the faces to be bonded in order to achieve sufficient bonding strength as a metal laminate material, and thus, has spent time on sputter etching treatment therefor. Therefore, particularly in the case of continuous production of a metal laminate material, a problem of reduction in the production efficiency exists, and further improvements have been required.

### Amended Pages 2 and 15 of the Specification (clean version)

### Citation List

### Patent Literature

Patent Literature 1: JP Patent Publication (Kokai) No. 1-224184A (1989)

### Summary of Invention

### Technical Problem

An object of the present invention is thus, in view of the aforementioned conventional circumstances, to provide a method for producing a metal laminate material that maintains sufficient bonding strength and has superior production efficiency.

### Solution to Problem

The inventors have extensively studied to solve the problem described above and found that the time required for producing a metal laminate material can be greatly reduced while high bonding strength is maintained by conducting sputtering treatment with inert gas ions under conditions where oxide layers present on the faces to be bonded are not completely removed but allowed to partly remain and by conducting a predetermined thermal treatment after temporary bonding is conducted, thereby having completed the present invention.

The present invention is defined by appended claim 1. A further preferable method for producing a metal laminate material is defined in appended claim 2.

Japanese Patent Application No. 2014-075586 is a priority document of the present application.

### Advantageous Effects of Invention

According to the present invention, the productivity on producing a metal laminate material is improved (the line speed is increased) as well as a metal laminate material having sufficient bonding strength can be obtained.

### Brief Description of Drawings

[Figure 1] Figure 1 is a schematic diagram illustrating a method for producing a metal laminate material of the present invention.
[Figure 2] Figure 2 is a graph showing the AES analysis results of the temporarily bonded laminates of Example 1 and Comparative Example 3.
[Figure 3] Figure 3 is a graph showing the peel strength of the metal laminate materials of Example 1 and Comparative Example 4 before and after thermally treated.
[Figure 4] Figure 4 is a graph showing the relationship between the etching amount by sputtering treatment on the stainless steel and the surface adsorbate layer.
[Figure 5] Figure 5 is a graph showing the relationship between the etching amount by sputtering treatment on the aluminum steel and the surface adsorbate layer.

### Description of Embodiments

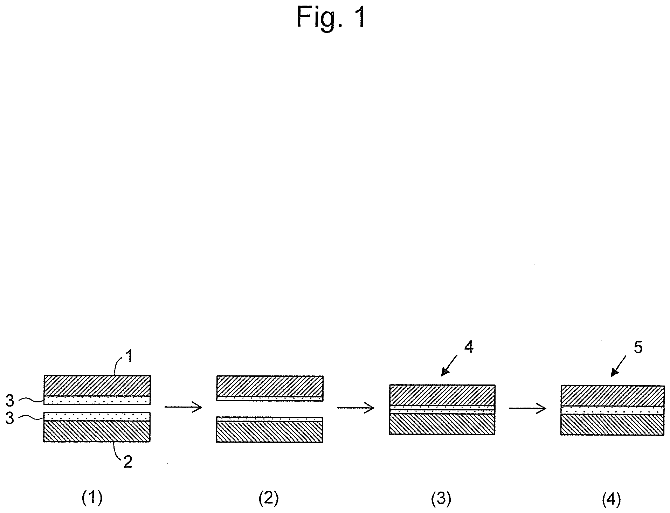

The method for producing a metal laminate material of the present invention will be described hereinbelow with reference to Figure 1.

When the materials of two sheets to be bonded by the method producing a metal laminate material (a sheet 1 and a sheet 2 in Figure 1) are each referred to as M1 and M2, each of M1 and M2 is a metal or alloy comprising any one or more selected from the group consisting of Mg, Al, Ti, Cr, Mn, Fe, Co, Ni, Cu, Zn, Nb, Mo, Pd, Ag, In, Sn, Hf, Ta, W, Pb, and Bi. Incidentally, the following description is made on the assumption that Tm1 > Tm2, where Tm1(K) is the melting point of M1 and Tm2(K) is the melting point of M2. Examples of such M1 and M2 include SUS304, SUS316, Ti alloys, and Cu alloys in addition to single materials composed of each metal as described above. When M1 is a metal or alloy comprising any one or more selected from the group consisting of Fe, Ni, Cu, Ti, and Mo and M2 is a metal or alloy comprising any one or more selected from the group of consisting of Mg, Al, and Sn, a preferable combination can be achieved.

The thickness of the two sheet can be selected as appropriate depending on the type of M1 and M2, processability on roll pressure bonding, the strength and applications of a metal laminate material to be produced and the like. The thickness is, but not limited to, preferably from 10 µm to 1 mm, for example.

As shown in (1) of Figure 1, an adsorbate layer including contamination and an oil content and oxide layers 3 are generally present on the surface layers of the faces of the sheet 1 and the sheet 2 to be bonded (such an adsorbate layer and an oxide layer are present on the opposite face to the face to be bonded, but not shown). On bonding two sheets, these faces to be bonded are subjected to sputtering treatment with an inert gas under vacuum in advance.

Then, as shown in (2) of Figure 1, the method for producing a metal laminate material of the present invention is characterized in that sputtering treatment is conducted so as to allow the oxide layers on the surface layer of the faces to be bonded to remain. Incidentally, under conditions where the oxide layer is partially etched and partially remains, the adsorbate layer on the surface layer of each face to be bonded becomes completely removed. According to the present invention in comparison with conventional methods for producing a metal laminate material, which completely remove the surface adsorbate layer and the oxide layer by etching by sputtering treatment (surface activating bonding methods), the time required for the sputtering treatment can be greatly reduced and thus the productivity of the metal laminate material can be improved. Specifically, the sputtering treatment time can be reduced by twofold to 630-fold relative to conventional methods for producing a metal laminate material, and thus the productivity of the metal laminate material can be increased remarkably.

The sputtering treatment can be conducted specifically as follows: two sheets are provided in the form of a long coil having a width of 100 mm to 600 mm, for example. An alternating current at 1 MHz to 50 MHz is applied between one electrode including the two sheets having a face to be bonded each grounded and the other electrode insulatingly supported to generate glow discharge, provided that the area of the electrode to be exposed to plasma generated by the glow discharge is one-third or less of the area of the other electrode. During the sputtering treatment, the grounded electrode can prevent increase in the temperature of each conveyed material by taking the form of a cooling roll.

In the sputtering treatment, etching of the faces to be bonded of the two sheets with an inert gas under vacuum completely removes the adsorbate layers on the surface layers and allows oxide layers on the surface layers to partially remain. Examples of the inert gas that can be applied include argon, neon, xenon, krypton, and mixed gases containing at least one of these. Adsorbate layers on the surface layers can be completely removed with an etching amount of the order of about 1 nm in terms of SiO₂.

Conditions for sputtering treatment are conditions under which the oxide layers partially remain and can be set as follows. By setting conditions that an etching amount by sputtering treatment on a face to be bonded is 1 nm to 10 nm in terms of SiO₂, the adsorbate layers become completely removed and the oxide becomes partially remaining. If energy sufficient to etch at least 1 nm of SiO₂ is applied, the amount of other materials etched is known. That is, when the sputtering rate value of SiO₂ is set to 1, the sputtering rates of other materials will be as follows: Al: 1, Ti: 0.5, Cr: 0.5, Mn: 3, Fe: 1, Co: 2, Ni: 2, Cu: 1.5, Nb: 1, Mo: 1, Pd: 4, Ag: 4, Sn: 4, Ta: 0.5, W: 0.5, and Pb: 10. The sputtering rate of stainless steel (SUS) is 1.

The sputtering treatment is conducted under vacuum, for example, at a plasma output of 100 W to 10 KW and a line speed of 1 m/minute to 30 m/minute. The degree of vacuum at this time may be, for example, from 1 × 10⁻⁵ Pa to 10 Pa although a higher degree is preferable in order to prevent readsorbates onto the surface. The temperature of the sheet 1 and the sheet 2 in the sputtering treatment is preferably maintained at ordinary temperature to 100°C from the viewpoint of prevention of softening.

Subsequently, in the method for producing a metal laminate material of the present invention, the faces to be bonded of the two sheets sputtering treated are temporarily bonded by roll pressure bonding to form a laminate material 4 as shown in (3) of Figure 1. The rolling line load for temporary bonding is, but not particularly limited to, from 0.1 to 10 tf/cm, for example. The temperature on temporary bonding by roll pressure bonding can be, but not particularly limited to, from ordinary temperature to 100°C.

The temporary bonding by roll pressure bonding is preferably conducted in a non-oxidizing atmosphere, for example, an inert gas atmosphere such as Ar in order to prevent decrease in the adhesion strength between the sheet 1 and the sheet 2 due to readsorption of oxygen onto the surfaces thereof.

Then, as shown in (4) of Figure 1, thermally treating the laminate material 4 obtained by temporary bonding allows atoms to diffuse through the bonding interface to improve the bonding strength, producing the metal laminate material 5 intended. Here, the production method according to the present invention is characterized in that, Tm1 > Tm2 where Tm1(K) is the melting point of M1 and Tm2(K) is the melting point of M2, the temperature of the thermal treatment is set to 0.45Tm2 or more and less than 0.45Tm1, provided that the temperature is not more than Tm2. In the present invention, in order to diffuse the metal having a lower melting point by thermal treatment, it is necessary to heat the laminate material at a temperature of at least 0.45Tm2 or more. In contrast, an extremely high thermal treatment temperature results in metal recrystallization, leading to decrease in the strength of the metal laminate material. Thus, thermal treatment is conducted in the range of less than 0.45Tm1, as a temperature which is less than the recrystallization temperature and at which atom diffusion moderately occurs. However, a thermal treatment temperature more than Tm2 is not suitable because M2 dissolves at the temperature. The melting temperatures of metals which are the subject of the present invention are shown in Table 1.

**[Table 1]**

| Metal | Melting point (°C) | Melting point (K) | 0.45×Melting point (K) | |
|---|---|---|---|---|
| Mg | 650 | 923 | 415.35 | (142.35°C) |
| Al | 660 | 933 | 419.85 | (146.85°C) |
| Ti | 1666 | 1939 | 872.55 | (599.55°C) |
| Cr | 1857 | 2130 | 958.5 | (685.5°C) |
| Mn | 1246 | 1519 | 683.55 | (410.55°C) |
| Fe | 1536 | 1809 | 814.05 | (541.05°C) |
| Co | 1495 | 1768 | 795.6 | (522.6°C) |
| Ni | 1455 | 1728 | 777.6 | (504.6°C) |
| Cu | 1085 | 1358 | 611.1 | (338.1°C) |
| Zn | 420 | 693 | 311.85 | (38.85°C) |
| Nb | 2477 | 2750 | 1237.5 | (964.5°C) |
| Mo | 2623 | 2896 | 1303.2 | (1030.2°C) |
| Pd | 1552 | 1825 | 821.25 | (548.25°C) |
| Ag | 962 | 1235 | 555.75 | (282.75°C) |
| In | 157 | 430 | 193.5 | (-79.5°C) |
| Sn | 232 | 505 | 227.25 | (-45.75°C) |
| Hf | 2233 | 2506 | 1127.7 | (854.7°C) |
| Ta | 2985 | 3258 | 1466.1 | (1193.1°C) |
| W | 3407 | 3680 | 1656 | (1383°C) |
| Pb | 1552 | 1825 | 821.25 | (548.25°C) |
| Bi | 271 | 544 | 244.8 | (-28.2°C) |

For example, when a stainless steel (SUS316L) and an aluminum are bonded, the melting point of the stainless steel, Tm1, is 1793 K (1520°C) and 0.45Tm1 = 806.85 K (533.85°C) while the melting point of the aluminum, Tm2, is 933 K (660°C) as shown in Table 1 above and 0.45Tm2 = 419.85 K (146.85°C). Thus, thermal treatment is conducted at 146.85°C to 533.85°C.

Alternatively, when a titanium and an aluminum are bonded, the melting point of titanium, Tm1, is 1939 K (1666°C) and 0.45Tm1 = 872.55 K (599.55°C), while the aluminum has 0.45Tm2 = 419.85 K (146.85°C). Thus, thermal treatment is conducted at a temperature of 146.85°C to 599.55°C.

As another example, when a molybdenum and an aluminum are bonded, the melting point of molybdenum, Tm1, is 2896 K (2623°C) and 0.45Tm1 = 1303.2 K (1030.2°C), while the aluminum has 0.45Tm2 = 419.85 K (146.85°C). Thus, thermal treatment is conducted at a temperature of 146.85°C to 660°C so as not to exceed the melting point of the aluminum, Tm2.

Thermal treatment time depends on metals. Occurrence of thermal diffusion preferably leads to an improvement in the adhesion. However, heating is required to be stopped before softening of the metal because extremely long heating time may lead to softening of the metal.

Through the thermal treatment step described above, a metal laminate material having high bonding strength can be produced more efficiently. Additionally, if the thermal treatment is applied, the strength of the metal laminate material itself is not decreased. A metal laminate material including three or more sheets bonded can be produced by conducting the production method according to the present invention a plurality of times. Examples of this metal laminate material include metal laminate materials having a three layered structure composed of Fe/Al/Fe and metal laminate materials having a three layered structure composed of Ni/Al/Ni.

### Examples

The present invention will be described in further detail hereinbelow referring to Examples and Comparative Examples, but the present invention is not intended to be limited to these Examples.

### (Example 1)

As the stainless steel, SUS304-BA (thickness 0.05 mm) was used, and as the aluminum, A1050-H18 (thickness 0.18 mm) was used. When each surface of SUS304-BA and A1050-H18 was measured with a scanning Auger Electron spectrometer (AES), the thickness of the SUS304-BA oxide layer was from 10 to 15 nm and the thickness of the A1050-H18 oxide layer was from 80 to 150 nm.

Subsequently, SUS304-BA and A1050-H18 were subjected to sputtering treatment. SUS304-BA was sputtered under vacuum of 0.1 Pa at a plasma output of 800W and a line speed of 3.5 m/minute and A1050-H18 was sputtered under vacuum of 0.1 Pa at a plasma output of 2600 W and a line speed of 3.5 m/minute to thereby completely remove the adsorbate layer on the surface of each SUS304-BA and A1050-H18. The inert gas used was Ar. The amount of SUS304-BA etched was about 2 nm in terms of SiO₂ and the amount of A1050-H18 etched was about 6 nm in terms of SiO₂. SUS304-BA and A1050-H18 after the sputtering treatment were temporarily bonded at ordinary temperature by roll pressure bonding at a rolling line load of 2 tf/cm (rolling load of 0.4 MN) to thereby form a laminate material.

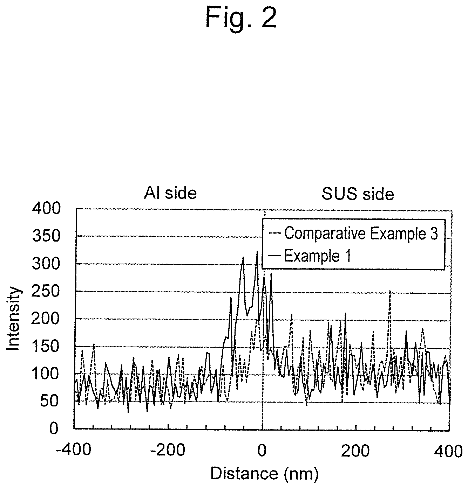

The temporarily bonded laminate material was subjected to AES analysis. The results of the AES analysis on the temporarily bonded laminate material of Example 1 and the temporarily bonded laminate material of Comparative Example 3 described below are shown in Figure 2. As shown in Figure 2, peaks derived from oxygen (O) were observed in the front and back of the temporarily bonded laminate material interface, and it was confirmed that SUS304-BA and A1050-H18 were temporarily bonded with an oxide layer remaining on the surface layer of each SUS304-BA and A1050-H18.

Then, the temporarily bonded laminate material was thermally treated at 240°C for 30 minutes. The metal laminate material obtained was measured for peel strength (90°), and bonding strength was evaluated.

### (Comparative Example 1)

Comparative Example 1 was the same as Example 1 except that no thermal treatment was conducted on the temporarily bonded laminate material.

### (Comparative Example 2)

Comparative Example 2 was the same as Example 1 except that no sputtering treatment on SUS304-BA and A1050-H18 was conducted. At the interface of the laminate material after temporarily bonded, oxide layers and adsorbate layers remained on the respective surfaces of SUS304-BA and A1050-H18.

### (Comparative Example 3)

As the stainless steel, SUS304-BA (thickness 0.05 mm) was used, and as the aluminum, A1050-H18 (thickness 0.17mm) was used. SUS304-BA and A1050-H18 were subjected to sputtering treatment. SUS304-BA was sputtered under vacuum of 0.1 Pa at a plasma output of 700 W for a time for sputtering the face to be bonded of 180 minutes, and A1050-H18 was sputtered under vacuum of 0.1 Pa at a plasma output of 700 W for a time for sputtering the face to be bonded of 180 minutes (the sheet was sputtered in a stationary state without moved. The line speed can be converted to a line speed of 5.6 × 10⁻³ m/minute under conditions of sputtering while the sheet passed through the line as in Example 1) to thereby completely remove adsorbate and oxide layers on the surface of SUS304-BA and A1050-H18. The amount of SUS304-BA etched was about 600 nm and the amount of A1050-H18 etched was about 460 nm. SUS304-BA and A1050-H18 after the sputtering treatment were temporarily bonded at ordinary temperature by roll pressure bonding at a rolling line load of 2 tf/cm (rolling load of 0.4 MN) to thereby form a laminate material. The temporarily bonded laminate material was measured for peel strength (90°).

### (Comparative Example 4)

The temporarily bonded laminate material obtained as in Comparative Example 3 was thermally treated at 240°C for 30 minutes. The metal laminate material obtained was measured for peel strength (90°).

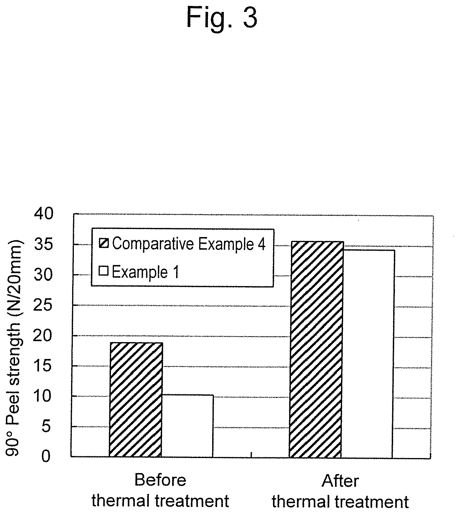

The peel strengths of the metal laminate materials produced in Example 1 and Comparative Example 1 to 4 are shown in Table 2. The peel strengths of the metal laminate materials of Example 1 and Comparative Example 4 before and after the thermal treatment are shown in Figure 3. The laminate materials before the thermal treatment of the metal laminate materials of Example 1 and Comparative Example 4 respectively correspond to the laminate materials of Comparative Examples 1 and 3.

**[Table 2]**

| | Etching amount (nm) | | Interface oxide layer after temporary bonding | Thermal treatment temperature (°C) | Peel strength (N/20mm) |
|---|---|---|---|---|---|
| | Al face | SUS face | | | |
| Example 1 | 6 | 2 | Yes | 240 | 34 |
| Comparative Example 1 | 6 | 2 | Yes | No | 10 |
| Comparative Example 2 | 0 | 0 | Yes, including adsorbates | 240 | 0 |
| Comparative Example 3 | 460 | 600 | No | No | 19 |
| Comparative Example 4 | 460 | 600 | No | 240 | 36 |

As shown in Table 2, the metal laminate material of Example 1 achieved improved peel strength by being thermally treated (Example 1 and Comparative Example 1). Additionally, the metal laminate material of Example 1, which was obtained by allowing oxide layers to remain on the surface of each SUS304-BA and A1050-H18, achieved peel strength equivalent to that of the metal laminate material of Comparative Example 4, which was obtained by completely removing oxide layers from the surface of each SUS304-BA and A1050-H18. Example 1 was also able to reduce the time required for the sputtering treatment by about 630-fold relative to Comparative Example 4 (calculated from the line speed of 3.5 m/minute in Example 1 and the converted value of line speed of 5.6 × 10⁻³ m/minute in Comparative Example 4). As seen from Figure 3, the metal laminate material of Example 1 exhibited an improvement in the peel strength before and after the thermal treatment greater than that of the metal laminate material of Comparative Example 4.

### (Examples 2 to 5 and Comparative Examples 5 to 7)

In Examples 2 to 5 and Comparative Examples 5 to 7, influences of the thermal treatment temperatures of the temporarily bonded laminate materials on the peel strength and hardness of the metal laminate materials to be obtained were examined.

In Examples 2 to 5 and Comparative Examples 5 to 7, temporarily bonded laminate materials were obtained in the same manner as Example 1 except that SUS304-BA having a thickness of 0.05 mm was replaced with SUS304-1/2H having a thickness of 0.1 mm and A1050-H18 having a thickness of 0.18 mm was replaced with AL1050 (H24) having a thickness of 0.4 mm, that sputtering treatment was conducted by changing the line speed of 3.5 m/minute to a line speed of 3.0 m/minute, and that temporary bonding by roll pressure bonding was conducted by changing the rolling line load of 2 tf/cm to a rolling line load of about 2.8 tf/cm. The amount of SUS304-1/2H etched was 3 nm in terms of SiO₂ and the amount of AL1050 (H24) etched was 5 nm in terms of SiO₂. The temporarily bonded laminate materials obtained were thermally treated at a predetermined temperature for 240 minutes. The thermal treatment temperatures in Examples 2 to 5 and Comparative Examples 5 to 7 are shown in Table 3. The metal laminate materials obtained were measured for the amount of iron (Fe) at a point 5 mm in the aluminum layer from the bonding interface of the metal laminate materials, peel strength (90°), and hardness on the SUS side. The results are shown in Table 3.

**[Table 3]**

| | Etching amount (nm) | | Interface oxide layer after temporary bonding | Thermal treatment temperature (°C) | Amount of Fe at point 5 mm into the aluminum layer from interface (atm%) | Peel strength (N/20mm) | Hardness Hv |
|---|---|---|---|---|---|---|---|
| | Al face | SUS face | | | | | |
| Example 2 | 5 | 3 | Yes | 200 | 8.1 | 49 | 390 |
| Example 3 | 5 | 3 | Yes | 300 | 8.8 | 85 | 392 |
| Example 4 | 5 | 3 | Yes | 400 | 10.7 | 130 | 393 |
| Example 5 | 5 | 3 | Yes | 500 | 15 | Al breakage | 369 |
| Comparative Example 5 | 5 | 3 | Yes | No | 0 | 22 | 393 |
| Comparative Example 6 | 5 | 3 | Yes | 100 | 2.6 | 24 | 393 |
| Comparative Example 7 | 5 | 3 | Yes | 600 | - | Delamination | 322 |

As shown in Table 3, the metal laminate materials of Examples 2 to 5, of which thermal treatment temperatures were 0.45Tm2 or more and less than 0.45Tm1, had higher peel strength as well as higher hardness than those of metal laminates of Comparative Examples 5 to 7, of which thermal treatment temperatures were outside this temperature range. As for the amount of iron (Fe) at a point 5 mm in the aluminum layer from the bonding interface of the metal laminate materials, as the thermal treatment temperature was increased in the measurement range, diffusion of the iron, which was a component of stainless steel, into the aluminum layer was increased. This is assumed to increase the peel strength of the metal laminate material. Within the range of the thermal treatment temperature of 0.45Tm2 or more and less than 0.45Tm1, the higher the thermal treatment temperature became, the higher the peel strength became.

### (Removal of surface adsorbate layer)

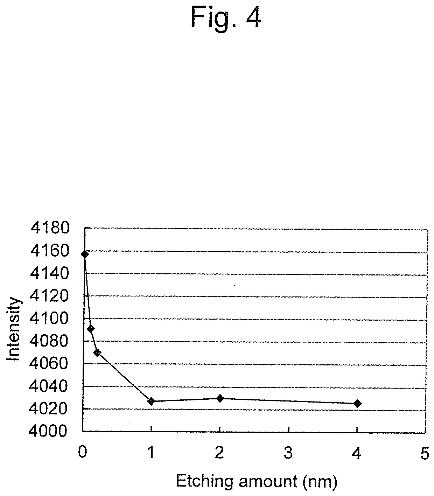

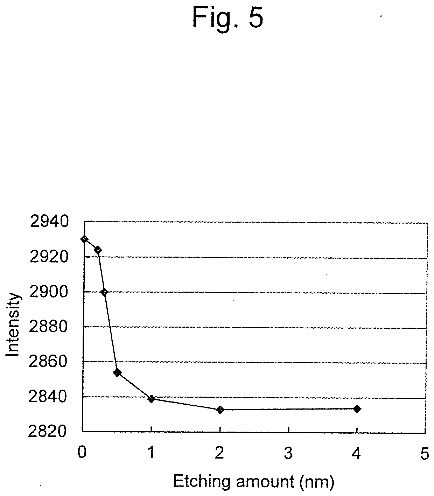

The relationship between the etching amount by sputtering treatment and the surface adsorbate layer was examined for each of a stainless steel (SUS316) and an aluminum (A1050). The results for the stainless steel are shown in Figure 4 and the results for the aluminum are shown in Figure 5. As shown in Figure 4 and Figure 5, the surface adsorbate layer was completely removed by etching to of the order of about 1 nm in terms of SiO₂both in the stainless steel and the aluminum.

### Reference Signs List

- 1: sheet
- 2: sheet
- 3: oxide layer
- 4: laminate material
- 5: metal laminate material

## Claims

1. A method for producing a metal laminate material by bonding two sheets, one sheet composed of a material M1 and the other sheet composed of a material M2,
M1 being a stainless steel, Ti or a titanium alloy, or Mo or a molybdenum alloy,
M2 being Al or an aluminum alloy,
wherein the method comprises the steps of:
subjecting the faces to be bonded of the two sheets to sputtering treatment with inert gas ions under vacuum such that oxide layers on surface layers remain, wherein an etching amount by sputtering treatment on a face to be bonded is 1 nm to 10 nm in terms of SiO₂, i.e. energy sufficient to etch 1 nm to 10 nm of SiO₂ is applied;
temporarily bonding the two sheets by roll pressure bonding; and
conducting a thermal treatment to thereby bond the two sheets; and
wherein Tm1 > Tm2 where Tm1 in Kelvin is the melting point of M1 and Tm2 in Kelvin is the melting point of M2, the temperature of the thermal treatment is 0.45Tm2 or more and less than 0.45Tml, provided that the temperature is not more than Tm2, and wherein the remains of the oxide layers are confirmable by observing peaks derived from oxygen in the front and back of the temporarily bonded laminate material interface by Auger electron spectrometer (AES).

2. A method for producing a metal laminate material, wherein three or more sheets are bonded by conducting the production method according to claim 1 a plurality of times.

## Patentansprüche

1. Verfahren zur Herstellung eines Metalllaminatmaterials durch Verbinden zweier Bögen, wobei ein Bogen aus einem Material M1 besteht und der andere Bogen aus einem Material M2 besteht,
wobei M1 ein rostfreier Stahl, Ti oder eine Titanlegierung, oder Mo oder eine Molybdänlegierung ist,
M2 A1 oder eine Aluminiumlegierung ist,
wobei das Verfahren die folgenden Schritte umfasst:
Unterziehen der zu verbindenden Seiten der zwei Bögen einer Sputterbehandlung mit Inertgas-Ionen unter Vakuum, so dass Oxidschichten auf Oberflächenschichten verbleiben, wobei eine durch die Sputterbehandlung geätzte Menge auf einer zu verbindenden Seite 1 nm bis 10 nm bezogen auf SiO₂ ist, d. h., eine Energie, die ausreicht, um 1 nm bis 10 nm SiO₂ zu ätzen, angewendet wird;
vorübergehendes Verbinden der zwei Bögen durch Walzendruckverbinden; und
Durchführen einer Wärmebehandlung, um die beiden Bögen dadurch zu verbinden; und
wobei Tm1 > Tm2, wobei Tm1 der Schmelzpunkt von M1 in Kelvin ist, und Tm2 der Schmelzpunkt von M2 in Kelvin ist, wobei die Temperatur der Wärmebehandlung 0,45Tm2 oder mehr und weniger als 0,45Tm1 beträgt, mit der Maßgabe, dass die Temperatur nicht mehr als Tm2 beträgt, und wobei die Reste der Oxidschichten bestätigt werden können, indem Spitzenwerte, die von Sauerstoff stammen, an der Vorder- und Rückseite der Grenzschicht des vorübergehend verbundenen Laminatmaterials durch ein Auger-Elektronenspektrometer (AES) beobachtet werden.

2. Verfahren zur Herstellung eines Metalllaminatmaterials, wobei drei oder mehr Bögen verbunden werden, indem das Herstellungsverfahren nach Anspruch 1 mehrmals durchgeführt wird.

## Revendications

1. Procédé pour fabriquer un matériau stratifié métallique en liant deux feuilles de métal, une feuille composée d'un matériau M1 et l'autre feuille composée d'un matériau M2,
M1 étant un acier inoxydable, Ti ou un alliage de titane, ou Mo ou un alliage de molybdène,
M2 étant Al ou un alliage d'aluminium,
le procédé comprenant les étapes consistant à :
soumettre les faces à lier des deux feuilles à un traitement de pulvérisation cathodique avec des ions de gaz inerte sous vide, de telle manière que des couches d'oxyde restent sur les couches de surface, dans lequel une quantité gravée par le traitement de pulvérisation cathodique sur une face à lier est de 1 nm à 10 nm en termes de SiO₂, c'est à dire, une énergie suffisant à graver de 1 nm à 10 nm de SiO₂ est appliquée ;
lier les deux feuilles temporairement en les liant par pression des rouleaux ; et
effectuer un traitement thérmique afin de lier les deux feuilles ; et
dans lequel Tm1 > Tm2, Tm1 étant le point de fusion de M1 en Kelvin, et Tm2 étant le point de fusion de M2 en Kelvin, la température du traitement thérmique est 0,45Tm2 ou supérieure et inférieure à 0,45Tm1, à condition que la température n'est pas supérieure à Tm2, et dans lequel les résidues des couches d'oxyde peuvent être confirmées en observant des pics dérivés de l'oxygène, à l'avant et à l'arrière de l'interface du matériau stratifié temporairement lié, au moyen d'un spectromètre électronique Auger (AES).

2. Procédé pour fabriquer un matériau stratifié métallique, dans lequel trois ou plusieurs feuilles sont liées en effectuant le procédé de fabrication selon la revendication 1 plusieurs fois.
